# EUROPEAN PATENT APPLICATION

(11) **EP 2 937 900 A2**
(43) Date of publication of application: **28.10.2015**
(21) Application number: 15001129.4
(22) Date of filing: 17.04.2015
(51) Int. Cl.: H01L 23/31, H01L 21/56, H01L 23/498, H01L 25/10, H01L 25/03, H01L 25/065, H01L 23/552, H01L 23/29, H01L 21/98

(54) **RECONSTITUTION TECHNIQUES FOR SEMICONDUCTOR PACKAGES**

(30) Priority: 22.04.2014 US 201461982442 P; 28.04.2014 US 201414263718
(71) Applicant: Broadcom Corporation, Irvine, CA 92617 (US)
(72) Inventor: Law, Edward, 92694 Ladera Ranch, CA (US); Khan, Rezaur, 92618 Irvine, CA (US); Hu, Kunzhong, 92618 Irvine, CA (US)
(74) Representative: Jehle, Volker Armin

(57) **Abstract**

Reconstitution techniques for semiconductor packages are provided. One reconstitution technique is used to encapsulate (348) a plurality of semiconductor packages (336,354,356) into a single multi-chip module (fig. 3e). Solder balls (326) coupled to each package may be partially exposed after reconstitution, which enables the packages to be coupled to another device. Another reconstitution technique is used to couple a plurality of semiconductor packages into a package-on-package module using self-alignment feature(s) (fig. 6k). The self-alignment feature(s) are exposed solder ball(s) (626) that are included in the bottom package of the package-on-package module. The exposed solder ball(s) serve as a frame of reference to other solder balls (624) that are encapsulated by an encapsulation material (634). After the location of these other solders balls are determined, through-mold vias (636a,636b) may be formed in the encapsulation material at locations corresponding to the other solder balls. The top package of the package-on-package module may then be coupled to the bottom package using these solder balls.

## Description

### CROSS REFERENCE TO RELATED APPLICATION

This application claims priority to U.S. Provisional Application Serial No. 61/982,442, filed April 22, 2014, and titled "Reconstitution Techniques for Semiconductor Packages," the entirety of which is incorporated by reference herein.

### BACKGROUND

### Technical Field

The subject matter described herein relates to reconstitution techniques for semiconductor packages.

### Description of Related Art

For mobile wireless devices, the number of functions desired to be performed by these devices continues to increase over time, and the number of semiconductor dies or chips developed to be implemented in these devices to perform these functions is therefore also increasing. Accordingly, the ability to combine multiple dies or chips into a single package becomes more important, as this provides the benefits of a smaller form factor with respect to the X, Y, and Z dimensions and lower cost.

### BRIEF SUMMARY

Methods, systems, and apparatuses are described for reconstitution techniques for semiconductor packages, substantially as shown in and/or described herein in connection with at least one of the figures, as set forth more completely in the claims.

According to an aspect of the invention, a multi-chip module is provided, comprising
at least two semiconductor packages, each of the at least two semiconductor packages comprising:
   a substrate having a first surface and a second surface that is opposed to the first surface;
   at least one semiconductor die coupled to the first surface of the substrate; and
   a first encapsulation material that encapsulates the at least one die and the first surface of the substrate; and
a second encapsulation material that at least partially encapsulates the at least two semiconductor packages.

Advantageously, each of the at least two semiconductor packages further comprise:
a plurality of interconnects coupled to the second surface of the substrate, the plurality of interconnects being partially encapsulated by the second encapsulation material.

Advantageously, the plurality of interconnects comprise a plurality of solder balls.

Advantageously, a first semiconductor package of the at least two semiconductor packages is laterally adjacent to a second semiconductor package of the at least two semiconductor packages such that the substrate of the first semiconductor package is substantially co-planar with the substrate of the second semiconductor package.

Advantageously, at least one of the at least two semiconductor packages comprises a plurality of dies.

Advantageously, at least one of the at least two semiconductor packages includes a shielding layer coupled to at least a respective first surface of the at least one of the at least two semiconductor packages.

Advantageously, the multi-chip module further comprises:
an interconnect that couples the at least two semiconductor packages, the interconnect being encapsulated by the second encapsulation material.

Advantageously, the interconnect comprises a bond wire.

According to an aspect, a method comprises:
positioning a first semiconductor package and a second semiconductor package such that the first semiconductor package is laterally adjacent to the second semiconductor package, each of the first semiconductor package and the second semiconductor package having a first surface and a second surface that is opposed to the first surface, each of the second surfaces having a plurality of interconnects; and
at least partially encapsulating the first semiconductor package and the second semiconductor package in an encapsulation material.

Advantageously, said positioning comprises:
applying an adhesive material layer to the first surface of the first semiconductor package and the first surface of the second semiconductor package.

Advantageously, said at least partially encapsulating comprising:
applying at least one film layer over the plurality of interconnects of the first semiconductor package and the second semiconductor package;
applying an encapsulation material between the at least one film layer and the second surfaces of the first and second semiconductor packages; and
removing the at least one film layer, the plurality of interconnects of the first semiconductor package and the second semiconductor package being at least partially exposed through the encapsulation material.

Advantageously, the plurality of interconnects comprise a plurality of solder balls.

Advantageously, at least one of the first semiconductor package or the second semiconductor package comprises a shielding layer that substantially encloses at least one integrated circuit die on the first surface of the at least one of the first semiconductor package or the second semiconductor package.

Advantageously, the method further comprises:
electrically and mechanically coupling the first semiconductor package and the second semiconductor package with an interconnect; and
said at least partially encapsulating comprising encapsulating the interconnect with the second encapsulation material.

Advantageously, said electrically and mechanically coupling comprises:
coupling together the first semiconductor package and the second semiconductor package with at least one bond wire.

According to an aspect, a semiconductor package comprises:
a substrate having a first surface and a second surface that is opposed to the first surface;
one or more first interconnects coupled to the first surface of the substrate;
one or more second interconnects coupled to the first surface of the substrate; and
an encapsulation material that fully encapsulates the one or more first interconnects and the first surface of the substrate, and partially encapsulates the one or more second interconnects such that the one or more second interconnects are partially exposed through the encapsulation material.

Advantageously, the one or more first interconnects and the one or more second interconnects are solder balls.

Advantageously, the semiconductor package further comprises:
an integrated circuit die that is mounted to the first surface of the substrate.

Advantageously, the one or more first interconnects are coupled to the first surface of the substrate via a first set of openings in an insulation layer formed over the first surface of the substrate, and the one or more second interconnects are coupled to the first surface of the substrate via a second set of openings formed in the insulation layer, wherein the first set of openings have a first width and the second set of openings have a second width that is smaller than the first width.

Advantageously, the second width being smaller than the first width causes a standoff of the one or more second interconnects from the first surface of the substrate to be greater than a standoff of the one or more first interconnects from the first surface of the substrate.

### BRIEF DESCRIPTION OF THE DRAWINGS/FIGURES

The accompanying drawings, which are incorporated herein and form a part of the specification, illustrate embodiments and, together with the description, further serve to explain the principles of the embodiments and to enable a person skilled in the pertinent art to make and use the embodiments.
FIG. 1 shows a cross-sectional view of a reconstituted multi-chip module in accordance with an embodiment described herein.
FIG. 2 shows a flowchart providing example steps for forming a reconstituted multi-chip module in accordance with an embodiment described herein.
FIG. 3A shows a cross-sectional view of three semiconductor packages that are positioned laterally adjacent to each another in accordance with an embodiment described herein.
FIG. 3B shows a cross-sectional view of the three semiconductor packages after being attached to an adhesive material layer in accordance with an embodiment described herein.
FIG. 3C shows a cross-sectional view of the three semiconductor packages after being coupled by one or more interconnects in accordance with an embodiment described herein.
FIG. 3D shows a cross-sectional view of a film-assisted molding process that is performed on the three semiconductor packages in accordance with an embodiment described herein.
FIG. 3E shows a cross-sectional view of a reconstituted multi-chip module in accordance with an embodiment described herein.
FIGS. 3F-3G show examples of strips and panels of packages that may be reconstituted, according to embodiments.
FIGS. 3H-3I show examples of encapsulated strips and panels of packages that may be reconstituted, according to embodiments.
FIG. 4 shows a cross-sectional view of a semiconductor package that includes a self-alignment feature in accordance with an embodiment described herein.
FIG. 5 shows a flowchart providing example steps for forming a semiconductor package that includes a self-alignment feature in accordance with an embodiment described herein.
FIG. 6A shows a cross-sectional view of a substrate after exposing one or more first regions of a conductive layer of the substrate via one or more first openings in accordance with an embodiment described herein.
FIG. 6B shows a cross-sectional view of the substrate after exposing one or more second regions of the conductive layer via one or more second openings in accordance with an embodiment described herein.
FIG. 6C shows a cross-sectional view of the substrate after being attached to an adhesive material layer in accordance with an embodiment described herein.
FIG. 6D shows a cross-sectional view of the substrate after forming one or more first interconnects on the one or more first regions of the conductive layer in accordance with an embodiment described herein.
FIG. 6E shows a plan view of the substrate shown in FIG. 6D in accordance with an embodiment described herein.
FIG. 6F shows a cross-sectional view of the substrate after forming one or more second interconnects on the one or more second regions of the conductive layer in accordance with an embodiment described herein.
FIG. 6G shows a plan view of the substrate shown in FIG. 6F in accordance with an embodiment described herein.
FIG. 6H shows a cross-sectional view of a film-assisted molding process that is performed on the substrate in accordance with an embodiment described herein.
FIG. 6I shows a cross-sectional view of the substrate after the film-assisted molding process is complete in accordance with an embodiment described herein.
FIG. 6J shows a plan view of the substrate shown in FIG. 6I in accordance with an embodiment described herein.
FIG. 6K shows a cross-sectional view of the substrate after forming through-mold vias through an encapsulation material that encapsulates the substrate in accordance with an embodiment described herein.
FIG. 6L shows a plan view of the substrate shown in FIG. 6K in accordance with an embodiment described herein.
FIGS. 6M and 6N show examples of strips and panels of substrates that may be processed in processed in parallel, according to embodiments.
FIGS. 6O and 6P show examples of encapsulated strips and panels of substrates that may be processed in processed in parallel, according to embodiments.

Embodiments will now be described with reference to the accompanying drawings. In the drawings, like reference numbers indicate identical or functionally similar elements. Additionally, the left-most digit(s) of a reference number identifies the drawing in which the reference number first appears.

### DETAILED DESCRIPTION

### I. Introduction

The present specification discloses numerous example embodiments. The scope of the present patent application is not limited to the disclosed embodiments, but also encompasses combinations of the disclosed embodiments, as well as modifications to the disclosed embodiments.

References in the specification to "one embodiment," "an embodiment," "an example embodiment," etc., indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to effect such feature, structure, or characteristic in connection with other embodiments whether or not explicitly described.

In embodiments, various reconstitution techniques for semiconductor packages are provided. In accordance with an embodiment, a reconstitution technique is used to encapsulate a plurality of semiconductor packages into a single multi-chip module. In accordance with such an embodiment, each semiconductor package may be assembled and/or tested before reconstitution. The semiconductor packages may also be electrically and mechanically coupled using one or more interconnect(s) (e.g., bond wires) during the reconstitution. Solder balls coupled to a substrate of each package may be partially exposed after reconstitution, which enables the single multi-chip module to be coupled to another device (e.g., a circuit board).

In accordance with another embodiment, a reconstitution technique is used to couple a plurality of semiconductor packages into a package-on-package module using a self-alignment feature. In accordance with such an embodiment, the self-alignment feature is at least one partially exposed solder ball that is included in the package to be positioned on the bottom of the package-on-package module. The at least one partially exposed solder ball serves as a frame of reference to other solder balls that are encapsulated (and therefore, not visible) by an encapsulation material. After the location of these other solder balls are determined using the at least one partially exposed solder mold, through-mold vias may be formed over locations corresponding to the other solder balls. The top package of the package-on-package module may then be coupled to the bottom package using these solder balls. Thus, the at least one partially exposed solder ball can be advantageously used to compensate for any potential misalignments that occur during the reconstitution process of the bottom package.

In embodiments, a multi-chip module is described. The multi-chip module includes at least two semiconductor packages. Each of the at least two semiconductor packages include a substrate, at least one semiconductor die, and a first encapsulation material. For each package, the substrate has a first surface and a second surface that is opposed to the first surface, the at least one semiconductor die is coupled to the first surface of the substrate, and the first encapsulation material encapsulates the at least one die and the first surface of the substrate. The multi-chip module further includes a second encapsulation material that at least partially encapsulates the at least two semiconductor packages.

An example method is described. The method includes positioning a first semiconductor package and a second semiconductor package such that the first semiconductor package is laterally adjacent to the second semiconductor package. Each of the first semiconductor package and the second semiconductor package has a first surface and a second surface that is opposed to the first surface. Each of the second surfaces has a plurality of interconnects. The first semiconductor package and the second semiconductor package are at least partially encapsulated in an encapsulation material.

A semiconductor package is also described. The semiconductor package includes a substrate, one or more first interconnects, one or more second interconnects, and an encapsulation material. The substrate has a first surface and a second surface that opposes the first surface. The one or more first interconnects are coupled to the first surface of the substrate. The one or more second interconnects are also coupled to the first surface of the substrate. The encapsulation material encapsulates the one or more first interconnects and the first surface of the substrate, and partially encapsulates the one or more second interconnects such that the one or more second interconnects are partially exposed (i.e., partially not covered by the encapsulating material, and therefore accessible externally to the semiconductor package).

### II. Example Embodiments

### A. RECONSITUTION TECHNIQUE FOR A MULTI-CHIP MODULE

As described above, a multi-chip module may be formed that includes a plurality of semiconductor packages that may optionally be electrically coupled together (e.g., by bond wires, etc.), in addition to being mechanically coupled together (e.g., held together by an encapsulation material, connected by bond wires or other conductors, etc.). The semiconductor packages are positioned laterally adjacent to each other, side-by-side (e.g., substrates of the packages are substantially co-planar with each other). Such a multi-chip module may be configured in various ways, in embodiments.

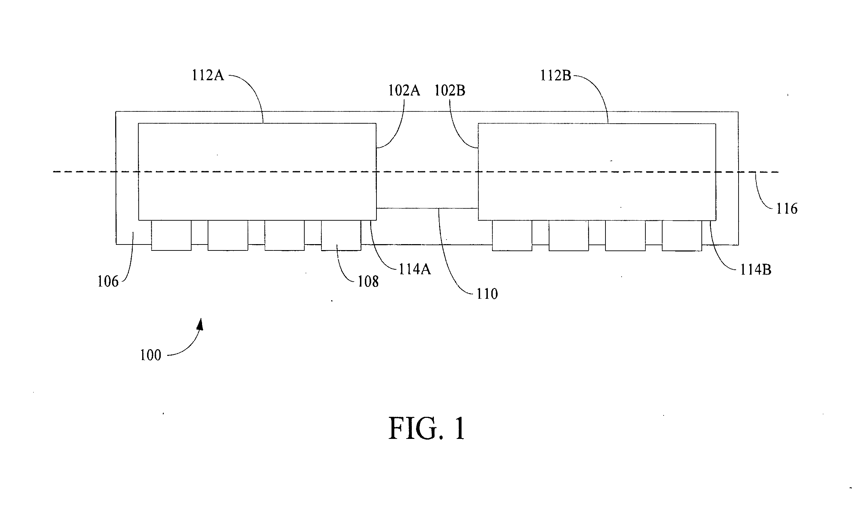

For instance, FIG. 1 shows a cross-sectional view of a reconstituted multi-chip module 100, according to an example embodiment. As shown in FIG. 1, multi-chip module 100 includes a first semiconductor package 102A and a second semiconductor package 102B that is positioned laterally adjacent to first semiconductor package 102A (i.e., packages 102A and 102B are substantially co-planar in a horizontal plane 116 in FIG. 1). In accordance with an embodiment, first semiconductor package 102A and/or second semiconductor package 102B may include a substrate and one or more semiconductor dies that are coupled to the substrate. In accordance with another embodiment, first semiconductor package 102A and/or second semiconductor package 102 may be wafer level packages that include semiconductor die(s) that are coupled to a wafer (i.e., the wafer level packages do not include a package substrate).

The semiconductor die(s) may be encapsulated by an encapsulation material. The substrate may include one or more conductive layers, vias, dielectric layers, etc. Each of first semiconductor package 102A and second semiconductor package 102 may also include a plurality of interconnects 108 that are used to interface the semiconductor die(s) located therein with a circuit board (e.g., a printed circuit board) (not shown). Interconnects 108 may include, but are not limited to, solder balls, pins, pillars, surface mount technology (SMT) pads, and/or the like.

First semiconductor package 102A and second semiconductor package 102B may be electrically and mechanically coupled to each other via one or more interconnect(s) 110. Interconnect(s) 110 may include one or more bond wires (also known as "wire bonds"), one or more passive components (e.g., resistor(s)), and/or the like.

First semiconductor package 102A and second semiconductor package 102B may be reconstituted together by at least partially encapsulating first semiconductor package 102A, second semiconductor package 102B, and interconnect(s) 110 in an encapsulation material 106. For example, as shown in FIG. 1, top surface(s) 112A and 112B, bottom surfaces 114A and 114B, the side surfaces of first semiconductor package 102A and second semiconductor package 102B, a space between first and second semiconductor packages 102A and 102B, and interconnect(s) 110 are encapsulated by encapsulation material 106. Furthermore, interconnects 108 are partially encapsulated by encapsulation material 106, thereby enabling multi-chip module 100 to be coupled to a circuit board by the exposed portions of interconnects 108

In accordance with an embodiment, encapsulation material 106 may comprise a different material than the encapsulation material used to encapsulate the semiconductor die(s) of first semiconductor package 102A and second semiconductor package 102B. For example, encapsulation material 106 may comprise a lower grade material having a relatively large filler size (e.g., a filler size of 40-50 microns) and/or having a substantially standard or higher alpha particle emission rate, whereas the encapsulation material that encapsulates the semiconductor die(s) included in first semiconductor package 102A and second semiconductor package 102B may comprise a higher grade material, such as a material having a filler size that has a relatively low alpha particle emission rate (e.g., a filler size of less than 20 microns and/or an alpha particle rate lower than that of encapsulation material 106).

While FIG. 1 shows multi-chip module 100 as including two semiconductor packages, it is noted that, in certain embodiments, multi-chip module 100 may include any number of semiconductor packages. In accordance with such embodiments, the semiconductor packages may be positioned adjacent to each another in any fashion.

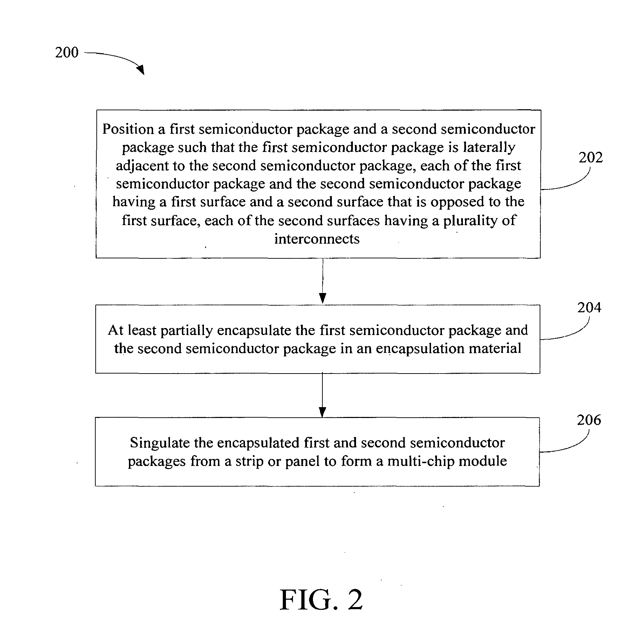

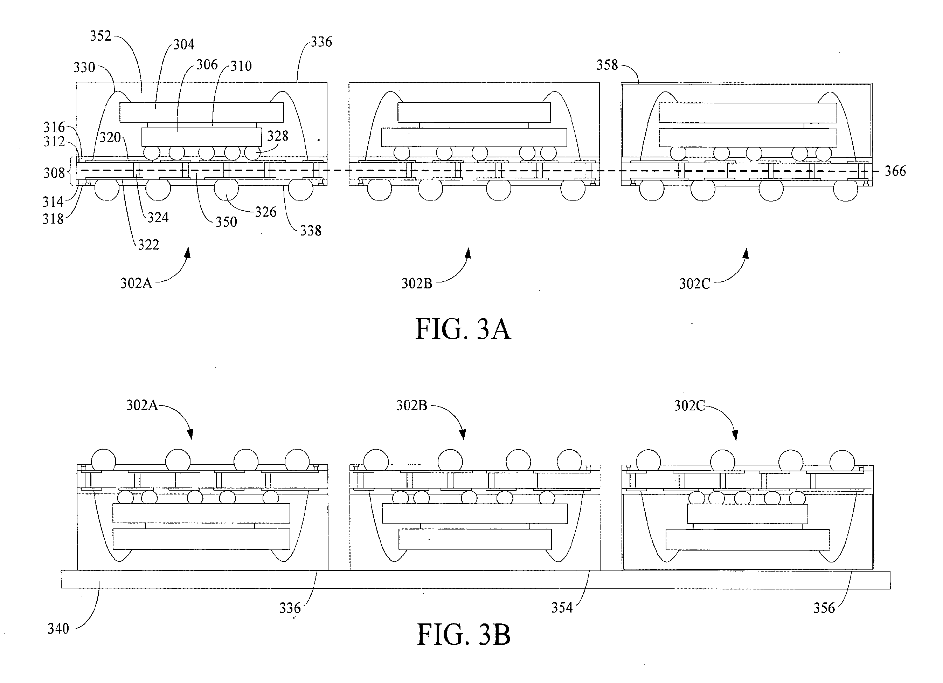

Semiconductor packages 102A and 102B (and additional packages) may be reconstituted into a multi-chip module in various ways, in embodiments. For instance, FIG. 2 shows a flowchart 200, which is a process for forming a reconstituted multi-chip module, according to an embodiment. Flowchart 200 is described below with reference to FIGS. 3A-3E, for illustrative purposes. FIG. 3A-3E show cross-sectional views of three semiconductor packages 302A, 302B, and 302C in accordance to embodiments. Note that not all steps of flowchart 200 need to be performed in all embodiments. Other structural and operational embodiments will be apparent to persons skilled in the relevant art(s) based on the discussion provided herein.

Flowchart 200 begins with step 202. In step 202, a first semiconductor package and a second semiconductor package are positioned such that the first semiconductor package is laterally adjacent to the second semiconductor package. Each of the first semiconductor package and the second semiconductor package has a first surface and a second surface that is opposed to the first surface. Each of the second surfaces has a plurality of interconnects.

For example, FIG. 3A shows a cross-sectional view of three semiconductor packages 302A, 302B, and 302C that are positioned laterally adjacent to each another. First semiconductor package 302A has a first surface 336 and a second surface 338 that is opposed to first surface 336. First semiconductor package 302A may include one or more semiconductor dies (e.g., first semiconductor die 304 and second semiconductor die 306) that may be stacked (as in FIG. 3A) or positioned adjacent to each other, a substrate 308, and an array of interconnects 326 that are coupled to second surface 338. A non-active surface of first semiconductor die 304 may be mounted to a non-active surface of second semiconductor die 306 using an adhesive material layer 310. Substrate 308 may include a core layer 350 (e.g., a dielectric material layer) that has a first surface 312 and a second surface 314 that is opposed to first surface 312. Substrate 308 may also include a first conductive layer 320 that is formed on first surface 312 and a second conductive layer 322 that is formed on second surface 314. Substrate 308 may further include a first insulation layer 316 that is formed over first surface 312 and first conductive layer 320 and a second insulation layer 318 that is formed over second surface 314 and second conductive layer 322. Examples of first insulation layer 316 and second insulation layer 318 may include, but are not limited to, a passivation layer or a solder mask layer. Further electrically conductive and/or electrically insulating layers may be stacked on core layer 350 in embodiments.

A plurality of bond wires 330 may couple terminals (not shown) on an active surface of first semiconductor die 304 to first conductive layer 320 (e.g., to conductive traces, pads, and/or other features). Second semiconductor die 306 may have a plurality of interconnects 328 that couple terminals (not shown) on an active surface of second semiconductor die 306 to first conductive layer 320. Examples of interconnects 328 may include, but are not limited to, solder balls, pins, SMT pads and/or the like.

Interconnects 326 may be used to mount first semiconductor package 302A to a circuit board (not shown) (e.g., by reflow soldering, etc.). Interconnects 326 may be, but are not limited to, solder balls, pins, pillars, surface mount technology (SMT) pads, and/or the like. As shown in FIG. 3A, interconnects 326 are coupled to second conductive layer 322 of substrate 308. Interconnects 326 are electrically coupled through substrate 308 by vias 324 included in core layer 350 to first conductive layer 320. Bond wires 330 and interconnects 328 are thus coupled to interconnects 326, thereby enabling signals of first semiconductor die 304 and second semiconductor die 306 to be electrically coupled to interconnects 326.

Encapsulation material 352 covers first semiconductor die 304, second semiconductor die 306, bond wires 330, interconnects 328, and first insulation layer 316. Encapsulation material 352 may be any suitable type of encapsulating material (high, medium, or low grade) known to persons skilled in the relevant art(s). In one embodiment, encapsulation material 352 may comprise a high grade material (e.g., a material having a maximum filler size of less than 20 microns and/or having a low alpha particular emission rate).

Second semiconductor package 302B and third semiconductor package 302C may be configured in a similar manner as first semiconductor package 302A. As such, for brevity of description, the structures of packages 302B and 302C are not separately described in detail. It is noted that each of first semiconductor package 302A, second semiconductor package 302B, and third semiconductor package 302C may include any number of semiconductor dies having varying sizes and/or functionality. In addition, first semiconductor package 302A, second semiconductor package 302B, and third semiconductor package 302C may each include different features. For example, as shown in FIG. 3A, third semiconductor package 302C includes an electromagnetic interference (EMI) shielding layer 358. EMI shielding layer 358 may comprise a metal (e.g., copper, nickel, gold, silver, platinum, cobalt, titanium, chrome, zirconium, molybdenum, ruthenium, hafnium, tungsten, rhenium, and/or the like). In the example of package 302C, EMI shielding layer 358 encloses a pair of stacked dies on a top surface of the package substrate. In this manner, EMI shielding layer 358 performs EMI shielding with regard to radiation emitted from one or both of the dies during operation, and/or with regard to protecting the one or more dies during operation from EMI generated by sources external to package 302C.

As described above, semiconductor packages 302A, 302B, and 302C are positioned laterally adjacent to each another. For instance, semiconductor packages 302A, 302B, and 302C may be positioned such that substrate 308 of first semiconductor package 302A is substantially co-planar with the substrate of second semiconductor package 302B, and such that the substrate of second semiconductor package 302B is substantially co-planar with the substrate of third semiconductor package 302C.

In accordance with an embodiment, step 202 may further comprise attaching the first surface of the first semiconductor package and the first surface of the second semiconductor package to an adhesive material layer. For example, as shown in FIG. 3B, first surface 336 of first semiconductor package 302A, first surface 354 of second semiconductor package 302B, and first surface 356 of third semiconductor package 302C is attached to adhesive material layer 340. Adhesive material layer 340 may be a sheet or tape (e.g., paper, plastic, etc.) having an adhesive material on a surface thereof (a resin, glue, etc., that enables temporary application of, and later removal of, adhesive material layer 340 from the packages).

In accordance with another embodiment, step 202 may further comprise positioning other semiconductor packages proximate to semiconductor packages 302A, 302B, and 302C to form a strip (e.g., a single column) of semiconductor packages or a panel (e.g., a multi-dimensional array) of semiconductor packages. These other semiconductor packages may be used to form other multi-chip module(s).

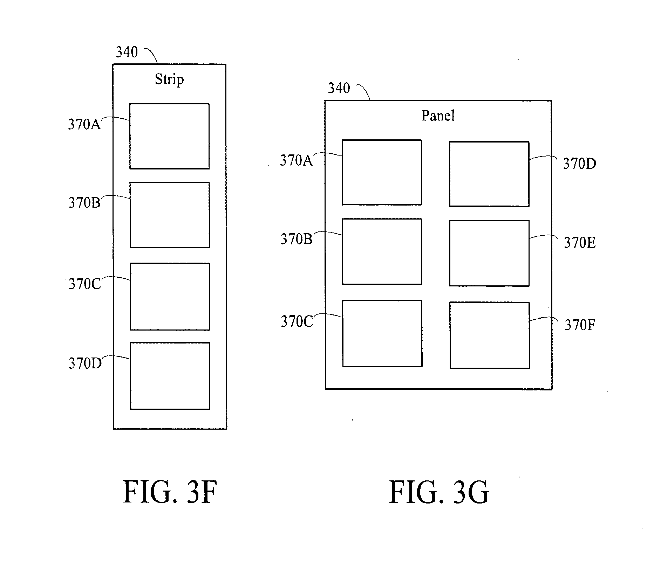

For instance, FIGS. 3F-3G show examples of strips and panels in which groups of semiconductor packages may be included, according to embodiments. In particular, FIG. 3F shows a first group 370A of semiconductor packages, a second group 370B of semiconductor packages, a third group 370C of semiconductor packages, and a fourth group 370D of semiconductor packages arranged in a strip format on adhesive material layer 340. Each of first group 370A, second group 370B, third group 370C, and fourth group 370D may include a plurality of semiconductor packages (e.g., first semiconductor package 302A, second semiconductor package 302B, and third semiconductor package 302C, as shown in FIGS. 3A-3B). FIG. 3G shows first group 370A of semiconductor packages, second group 370B of semiconductor packages, third group 370C of semiconductor packages, fourth group 370D of semiconductor packages, a fifth group 370E of semiconductor packages, and a sixth group 370F of semiconductor packages arranged in a panel format on adhesive material layer 340. As shown in FIG. 3G, first group 370A, second group 370B, third group 370C, fourth group 370D, fifth group 370E, and sixth group 370F may be arranged in substantially uniform rows and/or columns, though the scope of the embodiments is not limited in this respect.

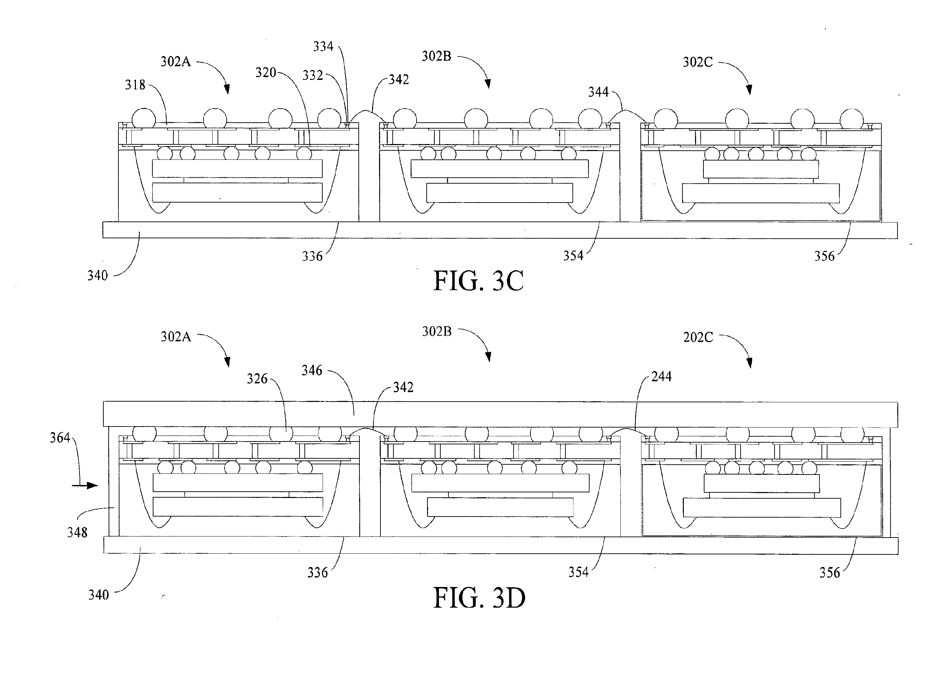

In accordance with a further embodiment, the first semiconductor package and the second semiconductor package may be mechanically and electrically coupled by interconnect(s). For example, as shown in FIG. 3C, first semiconductor package 302A and second semiconductor package 302B are mechanically and electrically coupled by interconnect 342, and second semiconductor package 302B and third semiconductor package 302C are mechanically and electrically coupled by interconnect 344. Interconnects 342 and 344 may enable signals from the semiconductor dies located in first semiconductor package 302A to be communicated between the semiconductor dies located in second semiconductor package 302B and/or third semiconductor package 302C. For example, each of interconnects 342 and 344 may be coupled to a respective first conductive layer (e.g., first conductive layer 320) of a respective semiconductor package (e.g., semiconductor packages 302A, 302B, and 302C). For instance, each of interconnects 342 and 344 may be coupled to a third conductive layer (e.g., third conductive layer 334), that is included in the second insulation layer (e.g., second insulation layer 318) of a respective semiconductor package. The third conductive layer is coupled to the first conductive layer by a via (e.g., via 332).

Interconnects 342 and 344 may include bond wire(s), passive component(s) (e.g., resistor(s)), and/or the like. Interconnects 342 and 344 may be applied in any manner, including by a pick-and-place apparatus, a wire bonding apparatus, etc. Although interconnects 342 and 344 are shown in FIG. 3C, each coupling a first package to a second package, any number of interconnects may be present to couple a particular package to one or more other packages, including numbers of interconnects in the ones, tens, hundreds, or even thousands.

Referring back to FIG. 2, in step 204, the first semiconductor package and second semiconductor package are at least partially encapsulated in an encapsulation material. In accordance with an embodiment, the first semiconductor package and the second semiconductor package may be at least partially encapsulated in the encapsulation material using a film-assisted molding process, an insert molding process (e.g., a rubber insert molding process), and/or the like. For example, FIG. 3D shows a film-assisted molding process where one or more layers of film 346 may be applied over interconnects 326 of first semiconductor package 302A, second semiconductor package 302B, and third semiconductor package 302C. For instance, film 346 may be a plastic or other layer of elastic material that conforms to interconnects 326, and/or can be held adjacent to interconnects 326 under pressure or compression. Thereafter, an encapsulation material 348 is applied (e.g., injected) from the side (as indicated by arrow 364) of first semiconductor package 302A, second semiconductor package 302B, and third semiconductor package 302C between film 346 and adhesive material layer 340. Encapsulation material 348 may be any suitable encapsulation material, as would be known to persons skilled in the relevant art(s). In an embodiment, encapsulation material 348 may comprise a low grade material (e.g., a material having a maximum filler size of 40-50 microns and/or having a relatively higher alpha particle emission rate (e.g., greater than 0.02 alpha particles/hour • cm2)).

After injecting and curing encapsulation material 348, layer(s) of film 346 are removed from interconnects 326 and/or adhesive material layer 340 is removed from first surface 336 of first semiconductor package 302A, first surface 354 of second semiconductor package 302B, and first surface 356 of third semiconductor package 302C, thereby forming a multi-chip module that includes partially exposed interconnects 326.

In accordance with an embodiment where other semiconductor packages are positioned proximate to semiconductor packages 302A, 302B, and 302C in a strip format or panel format (e.g., as shown in FIGS. 3F-3G), step 204 may comprise at least partially encapsulating the strip or panel of semiconductor packages in encapsulation material 348.

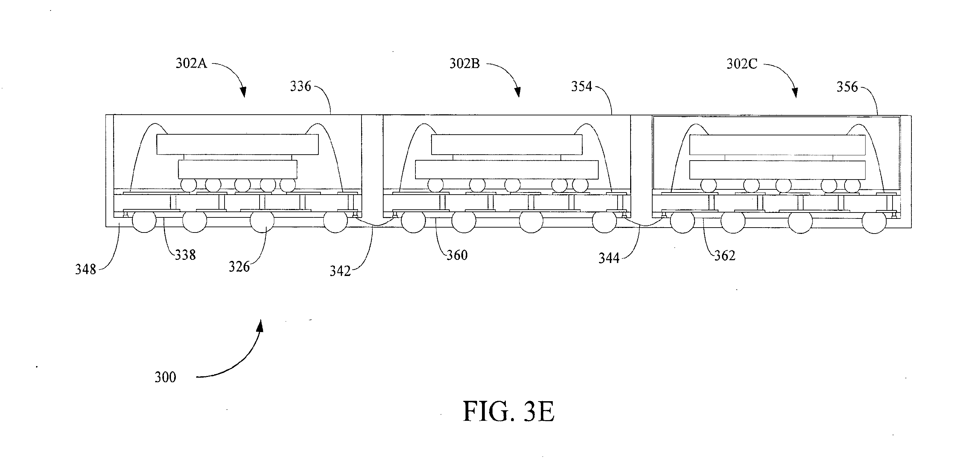

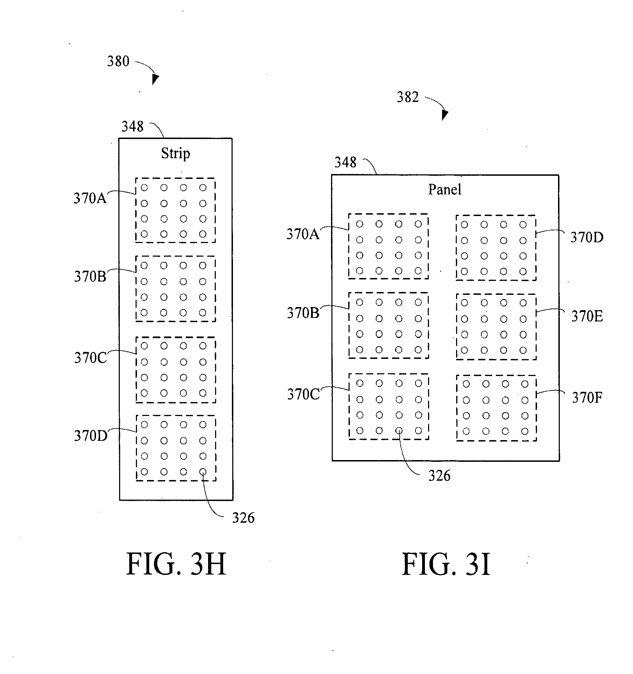

For instance, FIGS. 3H-3I show examples of encapsulated strips and panels in which groups of semiconductor packages may be included, according to embodiments. In particular, FIG. 3H shows an encapsulated strip 380 in which first group 370A of semiconductor packages, second group 370B of semiconductor packages, third group 370C of semiconductor packages, and fourth group 370D of semiconductor packages are encapsulated in encapsulation material 348. FIG. 3I shows an encapsulated panel 382 in which first group 370A of semiconductor packages, second group 370B of semiconductor packages, third group 370C of semiconductor packages, fourth group 370D of semiconductor packages, fifth group 370E of semiconductor packages, and sixth group 370F of semiconductor packages are encapsulated in encapsulation material 348. As shown in each of FIGS. 3H-3I, interconnects 326 of the semiconductor packages (e.g., semiconductor 302A, second semiconductor package 302B, and third semiconductor package 302C, as shown in FIG. 3E) included in each first group 370A, second group 370B, third group 370C, fourth group 370D, fifth group 370E and/or sixth group 370F are partially exposed such that interconnects 326 are protruding from encapsulation material 348.

Referring back to FIG. 2, in step 206, the encapsulated first and second semiconductor packages are singulated from a strip or panel to form a multi-chip module. For instance, in accordance with an embodiment where other semiconductor packages are positioned proximate to semiconductor packages 302A, 302B, and 302C in a strip format or panel format (e.g., as shown in FIGS. 3F-3G) and subsequently encapsulated by encapsulation material 348 (as described above with respect to step 204, and shown in FIGS. 3H-3I), flowchart 200 may optionally include step 206 of singulating the strip or panel of semiconductor package groups (e.g., first group 370A, second group 370B, third group 370C, fourth group 370D, fifth group 370E and/or sixth group 370F, as shown in FIGS. 3H-3I) into different multi-chip modules. Semiconductor packages may be singulated in any appropriate manner to physically separate groups of semiconductor packages from other groups of semiconductor packages, as would be known to persons skilled in the relevant art(s). For instance, semiconductor packages may be singulated by a saw, router, laser, or according to any other singulation technique.

FIG. 3E shows a resulting multi-chip module 300. As shown in FIG. 3E, each of first semiconductor package 302A, second semiconductor package 302B, and third semiconductor package 302C are partially encapsulated by encapsulation material 348. In particular, the spaces adjacent to each of first semiconductor package 302A, second semiconductor package 302B, and third semiconductor package 302C are encapsulated by encapsulation material 348, second surface 338 of first semiconductor package 302A, second surface 360 of second semiconductor package 302B, and third surface 362 of third semiconductor package 302C are encapsulated by encapsulation material 348, and interconnects 342 and 344 are encapsulated by encapsulation material 348. First surface 336 of first semiconductor package 302A, first surface 354 of second semiconductor package 302B, and first surface 356 of third semiconductor package 302C may be left exposed. Although, the scope of the embodiments is not limited in this respect. For example, in accordance with certain embodiments, first surface 336 of first semiconductor package 302A, first surface 354 of second semiconductor package 302B, and first surface 356 of third semiconductor package 302C may also be encapsulated by encapsulation material 348 (as shown in FIG. 1). Interconnects 326 are partially exposed such that interconnects 326 are protruding from encapsulation material 348. Interconnects 326 are left partially exposed due to the application of layer(s) of film 346 during the film-assisted molding process, as shown in FIG. 3D.

Accordingly, multi-chip module 300 may be mounted to a circuit board (e.g., PCB) using the exposed portions of interconnects 326. As noted above, in an embodiment, encapsulation material 348 that holds multi-chip module 300 together may be a low grade material, relative to a grade of encapsulation material 352 (e.g., a high grade) that encapsulates one or more of packages 302A, 302B, and/or 302C, to save multi-chip module costs.

### B. RECONSITUTION TECHNIQUE FOR PACKAGE-ON-PACKAGE MODULE USING A SELF-ALIGNMENT FEATURE

As described above, a semiconductor package may be formed that includes a semiconductor package having two sets of interconnects. An encapsulation material of the package fully encapsulates the first interconnect(s) on a substrate surface of the package, and partially encapsulates the second interconnect(s) on the substrate surface, such that the second interconnect(s) are partially exposed (i.e., partially not covered by the encapsulating material, and therefore accessible externally to the semiconductor package). Such a package may be configured in various ways, in embodiments.

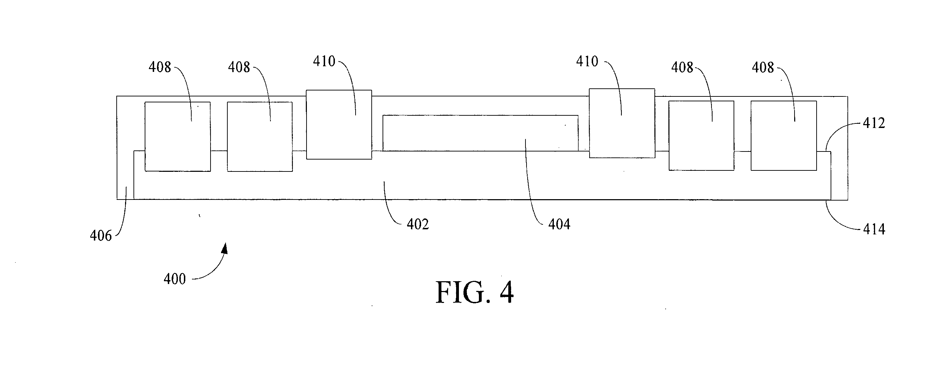

For instance, FIG. 4 shows a cross-sectional view of a semiconductor package 400 that includes self-alignment feature(s), according to an example embodiment. As shown in FIG. 4, semiconductor package 400 includes a substrate 402, one or more of semiconductor dies (e.g., semiconductor die 404), a plurality of first interconnects 408, and one or more second interconnects 410. Substrate 402 has a first surface 412 and a second surface 414 that is opposed to first surface 412. Substrate 402 may include one or more conductive layers, vias, insulation layers, etc. First interconnects 408 and second interconnect(s) 410 may be coupled to first surface 412 of substrate 402. Semiconductor die 404 may be mounted to first surface 412 (e.g., by using an adhesive material (not shown in FIG. 4)). Encapsulation material 406 may encapsulate semiconductor die(s) 404, first interconnects 408, first surface 412 of substrate 402, and the spaces adjacent to substrate 402. In accordance with an embodiment, encapsulation material 406 may also encapsulate second surface 414. Encapsulation material 406 partially encapsulates second interconnect(s) 410 such that a portion of each of second interconnect(s) 410 protrudes through encapsulation material 406. Encapsulation material 406 may be any suitable encapsulation material known to persons skilled in the relevant art(s).

Another semiconductor package (not shown) may be coupled to the top of semiconductor package 400 via first interconnects 408, thereby forming a package-on-package module. In order to couple another semiconductor package to first interconnects 408, through-mold vias may be formed in encapsulation material 406 at locations corresponding to first interconnects 408. Because first interconnects 408 are not visible due to being encapsulated by encapsulation material 406, second interconnects 410 may be used as a frame of reference to determine the location where the through-mold vias are to be formed. For instance, the distance between first interconnects 408 and second interconnect(s) 410 may be predetermined during the manufacturing process for semiconductor package 400. Accordingly, because the location of second interconnect(s) 410 is known due to second interconnect(s) 410 being partially exposed (e.g., can be ascertained by an imaging apparatus, etc.), the location of first interconnects 408 may be determined using the predetermined distance.

First interconnects 408 and second interconnect(s) 410 may include, but are not limited to, solder balls, pins, surface mount technology (SMT) pads, and/or the like.

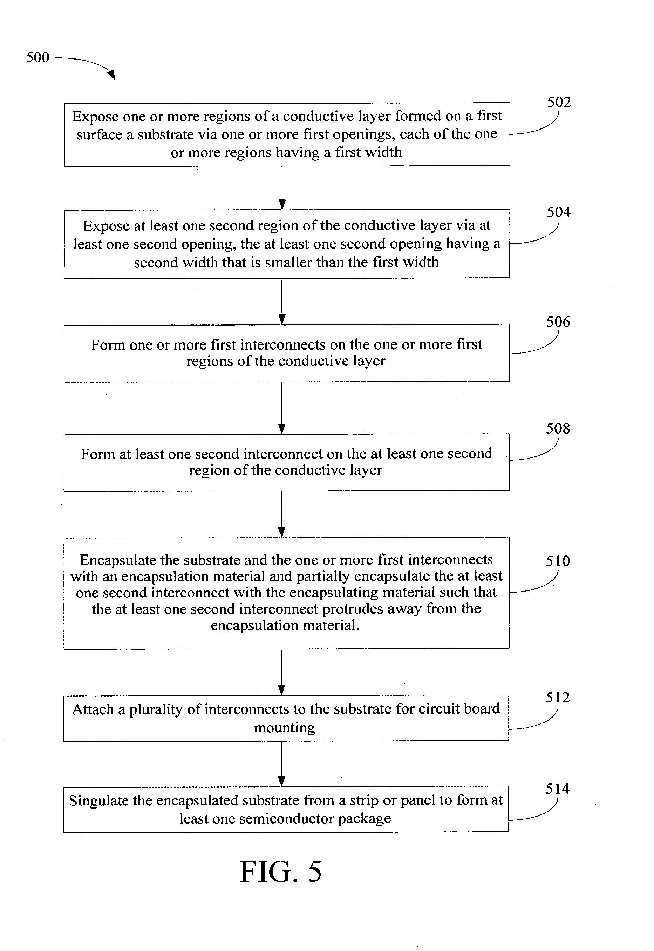

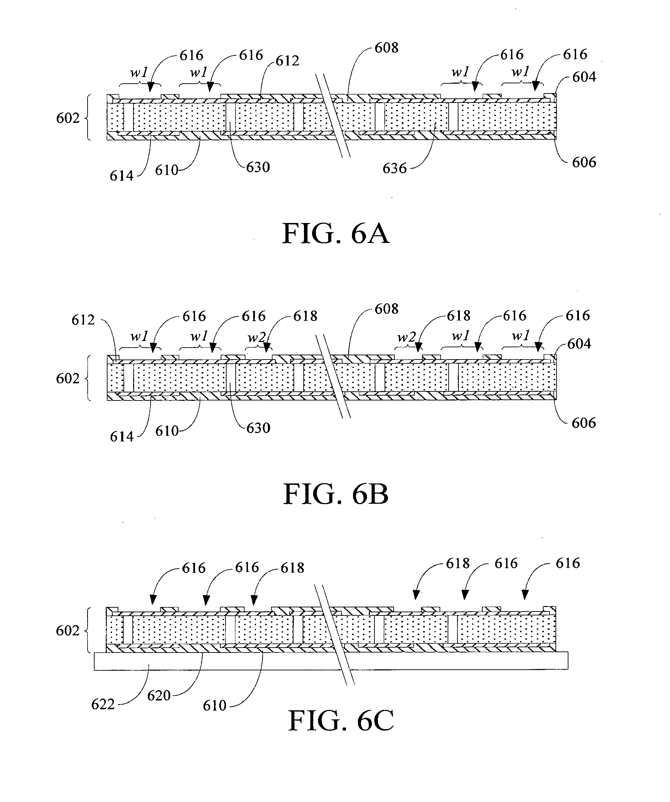

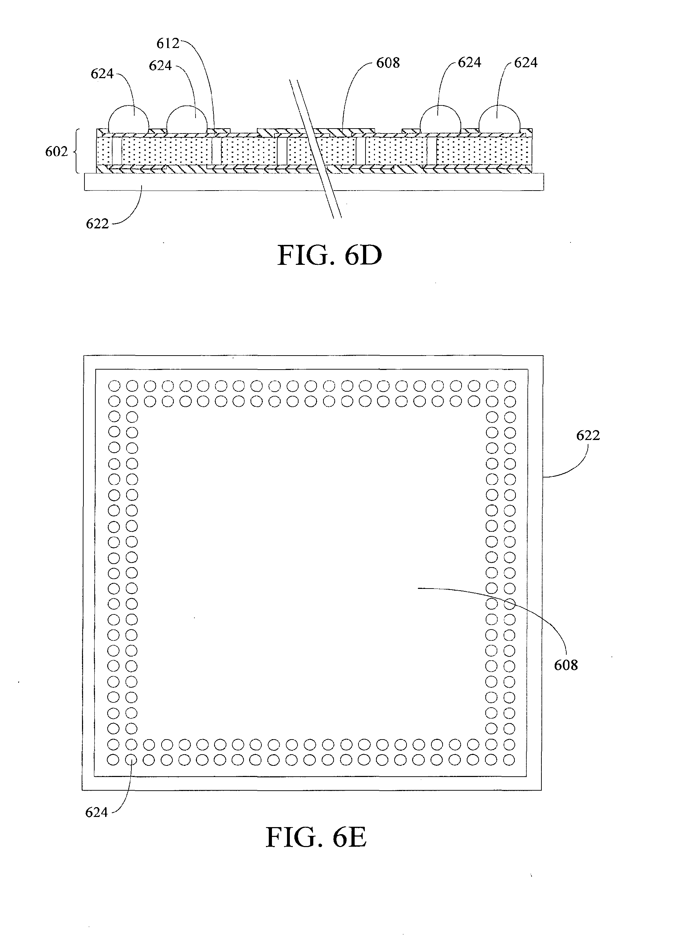

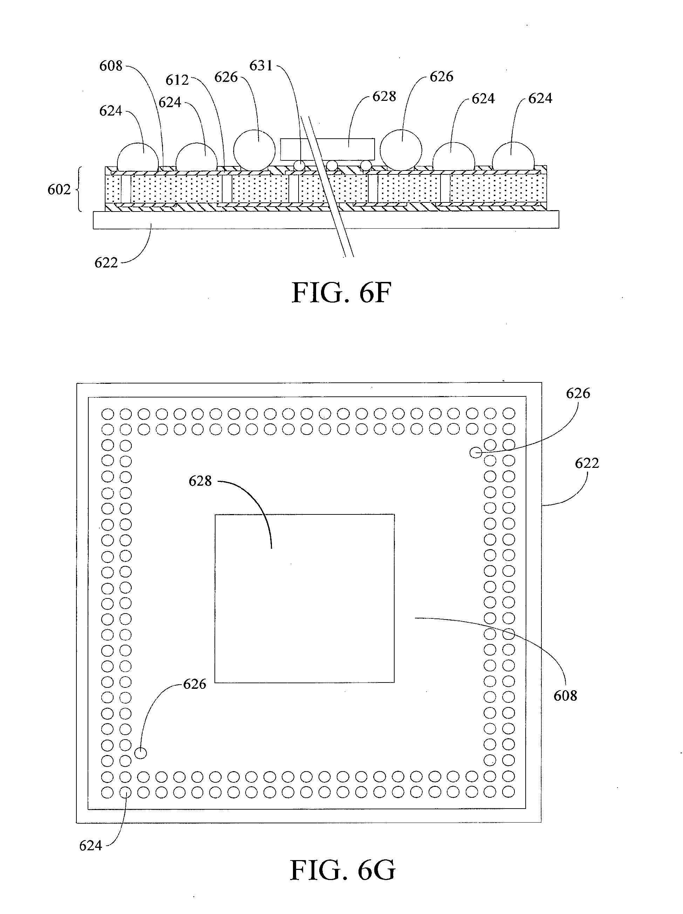

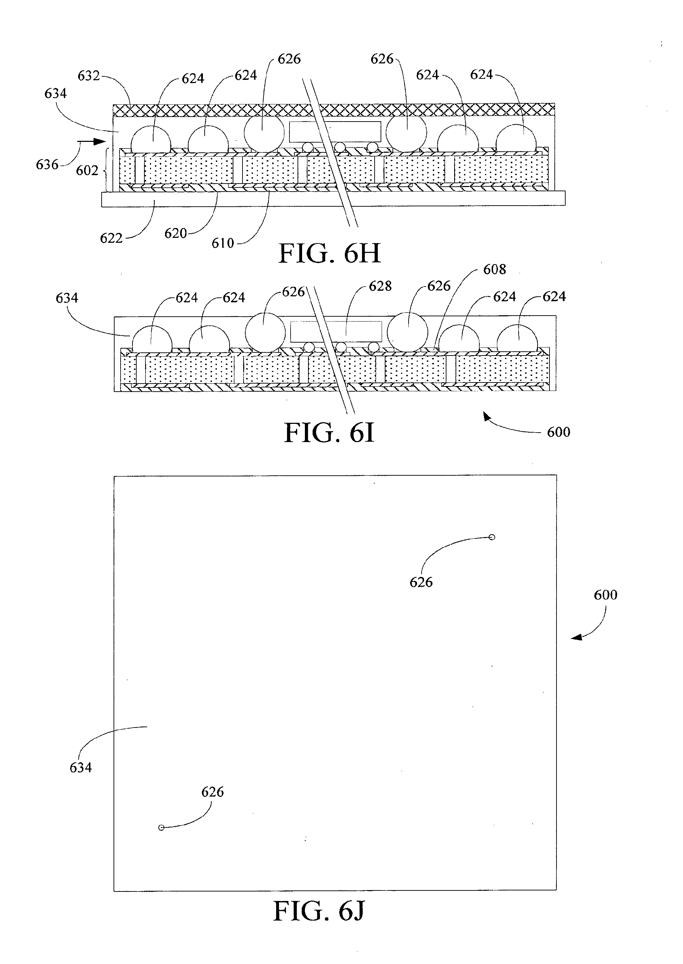

Semiconductor package 400 may be formed in various ways, in embodiments. For instance, FIG. 5 shows a flowchart 500, which is a process for forming a semiconductor package including self-alignment feature(s). The steps of flowchart 500 do not necessarily need to be performed in the order shown. All steps of flowchart 500 do not need to be performed in all embodiments. Flowchart 500 is described below with reference to FIGS. 6A-6I, for illustrative purposes. FIGS. 6A-6D, 6F, 6H, and 6I show a cross-sectional view of a substrate 602, and FIGS. 6E, 6G, and 6J show a plan view of the substrate 602 shown in FIGS. 6D, 6F, and 6I, respectively. Note that not all steps of flowchart 500 need to be performed in all embodiments. Other structural and operational embodiments will be apparent to persons skilled in the relevant art(s) based on the discussion provided herein.

Flowchart 500 begins with step 502. In step 502, one or more regions of a conductive layer formed on a substrate are exposed via one or more first openings, where each of the one or more regions have a first width. For example, as shown in FIG. 6A, substrate 602 may include a core layer 636 that has a first surface 604 and a second surface 606 that is opposed to first surface 604. Core layer 636 may comprise of a dielectric material. Substrate 602 may also include a first conductive layer 612 that is formed on first surface 604 and a second conductive layer 614 that is formed on second surface 606. Conductive layers 612 and 614 may each include one or more electrically conductive features, such as pads for mounting of interconnects such as solder balls, bumps, etc. Substrate 602 may further include a first insulation layer 608 that is formed over first surface 604 and first conductive layer 612 and a second insulation layer 610 that is formed over second surface 606 and second conductive layer 614. Examples of first insulation layer 608 and second insulation layer 610 may include, but are not limited to, a passivation layer or a solder mask layer. First conductive layer 612 and second conductive layer 614 may be electrically coupled by vias 630 included in core layer 636. Further electrically conductive layers and/or electrically insulating layers may be present on core layer 636.

In accordance with step 502, first openings 616 may be formed in first insulation layer 608 to expose first regions of first conductive layer 612. First openings 616 may have a first width of *w1*. First openings 616 may be formed in first insulation layer 608 in any manner, including by an etching process, by a developing process (e.g., where first insulation layer 608 is made of a polymer), etc.

In step 504, at least one second region of the conductive layer is exposed via at least one second opening, where the at least one second opening has a second width that is smaller than the first width. For example, as shown in FIG. 6B, second openings 618 are formed in first insulation layer 608, thereby exposing second regions of conductive layer 612. As shown, in FIG. 6B, second openings 618 have a second width w2 that is smaller than first width *w1*.

In accordance with an embodiment, flowchart 500 may optionally include the step of attaching the substrate to an adhesive material. For example, as shown in FIG. 6C, bottom surface 620 of second insulation layer 610 is attached to adhesive material layer 622. Adhesive material layer 622 may be a sheet or tape (e.g., paper, plastic, etc.) having an adhesive material on a surface thereof (a resin, glue, etc.), that enables temporary application of, and later removal of, adhesive material layer 340 from substrate 602. It is noted that other substrates may be positioned proximate to substrate 602 on adhesive material layer 622 to form a strip (e.g., a single column) of substrates or a panel (e.g., a multi-dimensional array) of substrates. These other substrates may be used to form other semiconductor packages.

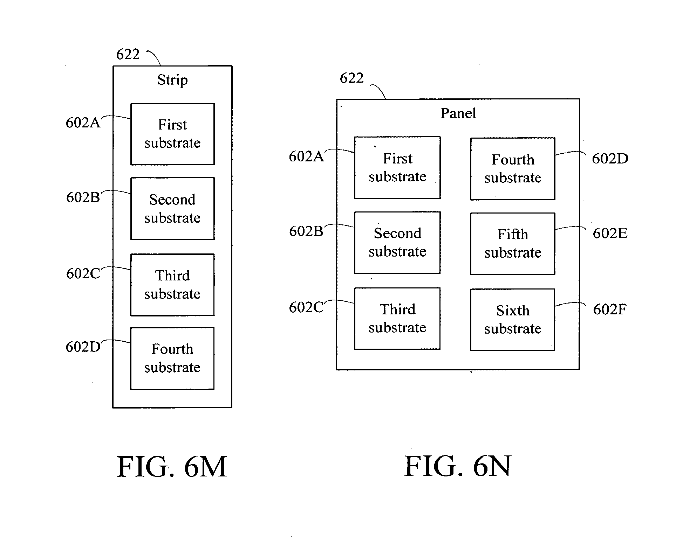

For example, FIGS. 6M and 6N show examples of strips and panels of substrates that may be processed in processed in parallel, according to embodiments. In particular, FIG. 6M shows a first substrate 602, a second substrate 602B, a third substrate 602C, and a fourth substrate 602D arranged in a strip format on adhesive material layer 622. FIG. 6N shows first substrate 602, second substrate 602B, third substrate 602C, a fourth substrate 602D, a fifth substrate 602E, and a sixth substrate 602F arranged in a panel format on adhesive material layer 622. As shown in FIG. 6N, first substrate 602, second substrate 602B, third substrate 602C, fourth substrate 602D, fifth substrate 602E, and sixth substrate 602F may be arranged in substantially uniform rows and/or columns, though the scope of the embodiments is not limited in this respect.

In step 506, one or more first interconnects are formed on the one or more first regions of the conductive layer. For example, as shown in FIGS. 6D and 6E, first interconnects 624 are formed on first regions of conductive layer 612. First interconnects 624 may include, but are not limited to, solder balls, pins, surface mount technology (SMT) pads, and/or the like. The first regions of conductive layer 612 may include solder ball pads or other electrically conductive features for receiving first interconnects 624.

In step 508, one or more second interconnects are formed on the one or more second regions of the conductive layer. For example, as shown in FIGS. 6F-6G, second interconnects 626 are formed on second regions of first conductive layer 612. Second interconnects 626 may include, but are not limited to, solder balls, pins, surface mount technology (SMT) pads, and/or the like. In accordance with an embodiment, first interconnects 624 and second interconnects 626 are the same shape and/or size. However, as shown in FIG. 6F, second interconnects 626 each have a greater standoff from first conductive layer 612 than first interconnects 624 - i.e., second interconnects 626 are positioned higher (e.g., have center points and outermost edges that are farther) from first conductive layer 612 than first interconnects 624. This difference in standoff is due to the width of the second openings being smaller than the width of the first openings, as shown above with respect to FIG. 6B. The smaller widths of the second openings prevent second interconnects 626 from settling in as close to first conductive layer 612 as first interconnects 626 can settle due to the greater width of the first openings.

As further shown in FIGS. 6F and 6G, one or more semiconductor dies 628 may also be coupled to substrate 602. For example, semiconductor die(s) 628 may be coupled to first conductive layer 612 by interconnects 631 (e.g., to land pads of first conductive layer 612, etc.).

In step 510, the substrate and the one or more first interconnects are encapsulated with an encapsulation material and the at least one second interconnect is partially encapsulated with the encapsulation material such that the at least one second interconnect protrudes away from the encapsulation material. In accordance with an embodiment, the encapsulation material may be applied using a film-assisted molding process. For example, as shown in FIG. 6H, one or more layers of film 632 may be applied over second interconnects 626.

Thereafter, an encapsulation material 634 is applied (e.g., injected or transferred) from the side (as indicated by arrow 636) of substrate 602. Note that encapsulation material 634 may be applied in step 510 in a similar manner as described with respect to step 204 (FIG. 2) above, or in an alternative manner.

After injecting encapsulation material 634, layer(s) of film 632 are removed from second interconnects 626 and/or adhesive material layer 622 is removed from bottom surface 620 of second insulation layer 610, thereby forming a semiconductor package that includes self-alignment features for determining a location for forming through-mold vias. FIG. 6I-6J show views of a resulting semiconductor package 600. As shown in FIG. 6I, semiconductor die 628, first interconnects 624, first insulation layer 608, and the spaces adjacent to substrate 602 are encapsulated by encapsulation material 634, and second interconnects 626 are partially encapsulated by encapsulation material 634 such that second interconnects 626 protrude away from encapsulation material 634.

In accordance with an embodiment where other substrates are positioned proximate to substrate 602 in a strip format or panel format (e.g., as shown in FIGS. 6M-6N), step 510 may comprise at least partially encapsulating the strip or panel of substrates in encapsulation material 634.

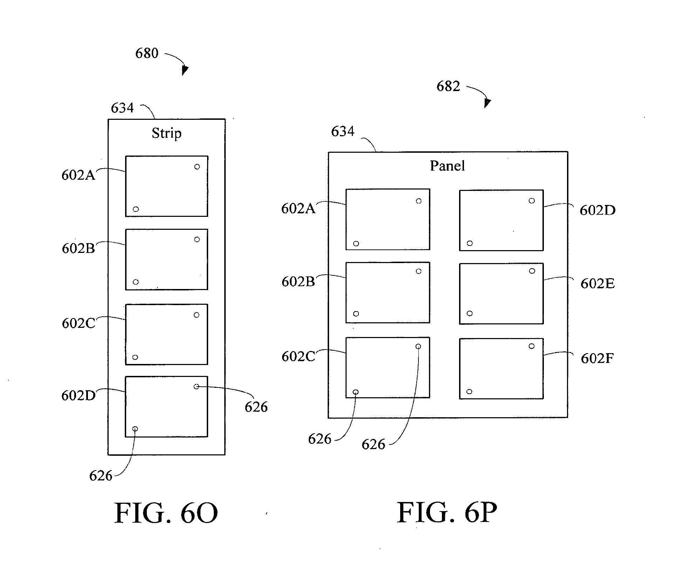

For instance, FIGS. 6O-6P show examples of encapsulated strips and panels in which substrates may be included, according to embodiments. In particular, FIG. 6O shows an encapsulated strip 680 in which first substrate 602A, second substrate 602B, third substrate 602C, and fourth substrate 602D are encapsulated in encapsulation material 634. FIG. 6P shows an encapsulated panel 682 in which first substrate 602A, second substrate 602B, third substrate 602C, fourth substrate 602D, fifth substrate 602E, and sixth substrate 602F are encapsulated in encapsulation material 634. As shown in each of FIGS. 6O-6P, second interconnects 626 of each of first substrate 602A, second substrate 602B, third substrate 602C, fourth substrate 602D, fifth substrate 602E, and sixth substrate 602F are partially encapsulated by encapsulation material 634 such that second interconnects 626 protrude away from encapsulation material 634.

In accordance with an embodiment, another semiconductor package (not shown) may be coupled to the top of semiconductor package 600 via first interconnects 624, thereby forming a package-on-package module. In order to couple another semiconductor package to first interconnects 624, through-mold vias may be formed in encapsulation material 643 at a location corresponding to first interconnects 624. Because first interconnects 624 are not visible due to being encapsulated by encapsulation material 634, second interconnects 626 may be used as a frame of reference to determine the location of the through-mold vias to be formed. For instance, a relative position, and/or the distance between first interconnects 624 and second interconnect(s) 626 may be predetermined during the manufacturing process for semiconductor package 600. Accordingly, since the location of second interconnects 626 is known due to second interconnects 626 being partially exposed, the location of first interconnects 624 may be determined using the relative position/predetermined distance.

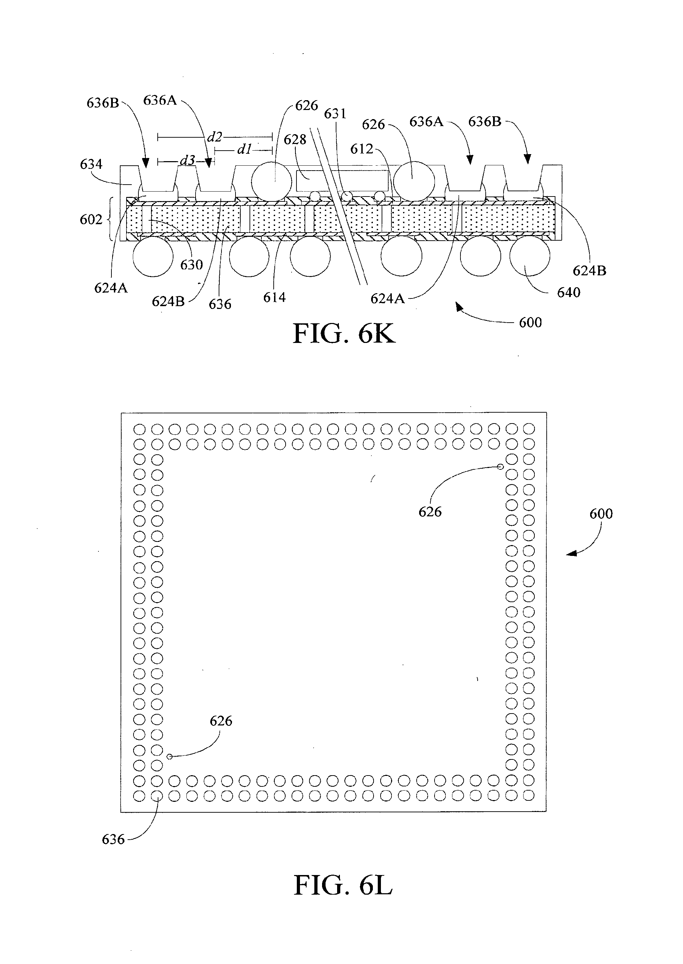

For instance, FIG. 6K shows a cross-sectional view of semiconductor package 600 having through-mold vias 636 formed therein, in accordance with an embodiment. FIG. 6L shows a plan view of semiconductor package 600 shown in FIG. 6K. As shown in FIGS. 6K-6L, through-mold vias 636 are formed in encapsulation material 634 at locations corresponding to first interconnects 624 based on the predetermined distances between first interconnects 624 and second interconnects 626. For example, through-mold vias 636A are formed a predetermined distance *d1* away from second interconnects 626, and through-mold vias 636B are formed a predetermined distance *d2* away from second interconnects 626. Alternatively, through-mold vias 636B may be formed based on a predetermined distance between first interconnects 624A and first interconnects 624B. For example, as shown in FIG. 6K, through-mold vias 636B may be formed a predetermined distance *d3* away from first interconnect 624A.

Through-mold vias 636 may be formed in any manner, including by a laser ablation process, drilling (e.g., mechanical drilling, laser drilling, etc.), by an etching process, etc.

Referring back to FIG. 5, in step 512, a plurality of interconnects is attached to the substrate for circuit board mounting. In accordance with an embodiment, a plurality of third interconnects 640 may be coupled to second conductive layer 614, which are used to mount semiconductor package 600 to a circuit board (not shown) (e.g., by reflow soldering, etc.). Third interconnects 640 may be, but are not limited to, solder balls, pins, pillars, surface mount technology (SMT) pads, and/or the like. As shown in FIG. 6K, third interconnects 640 are electrically coupled through substrate 602 by vias 630 included in core layer 636 to first conductive layer 612. First interconnects 624, second interconnects 626, and interconnects 631 may therefore be electrically coupled to third interconnects 640, thereby enabling signals of semiconductor die 628 and another semiconductor package coupled to semiconductor package 600 via interconnects 624/626 to be electrically coupled to third interconnects 640.

It is noted that while FIGS. 6E, 6G, and 6L depict first interconnects 624 as being arranged as a Ball Grill Array (BGA), it is noted that first interconnects 624 may arranged in accordance to other patterns.

In step 514, the encapsulated substrate is singulated from a strip or panel to form at least one semiconductor package. In accordance with an embodiment where other substrates are positioned proximate to substrate 602 in a strip format or panel format and undergo the process described by flowchart 500 to form other semiconductor packages including self-alignment feature(s), flowchart 500 may optionally include step 514 for singulating the strip or panel of such semiconductor packages into different semiconductor packages. Semiconductor packages may be singulated in any appropriate manner to physically separate semiconductor packages from each other, as would be known to persons skilled in the relevant art(s). For instance, semiconductor packages may be singulated by a saw, router, laser, or according to any other singulation technique.

### III. Conclusion

While various embodiments have been described above, it should be understood that they have been presented by way of example only, and not limitation. It will be apparent to persons skilled in the relevant art that various changes in form and detail can be made therein without departing from the spirit and scope of the embodiments. Thus, the breadth and scope of the embodiments should not be limited by any of the above-described exemplary embodiments, but should be defined only in accordance with the following claims and their equivalents.

## Claims

1. A multi-chip module, comprising
at least two semiconductor packages, each of the at least two semiconductor packages comprising:
a substrate having a first surface and a second surface that is opposed to the first surface;
at least one semiconductor die coupled to the first surface of the substrate; and
a first encapsulation material that encapsulates the at least one die and the first surface of the substrate; and
a second encapsulation material that at least partially encapsulates the at least two semiconductor packages.

2. The multi-chip module of claim 1, wherein each of the at least two semiconductor packages further comprise:
a plurality of interconnects coupled to the second surface of the substrate, the plurality of interconnects being partially encapsulated by the second encapsulation material.

3. The multi-chip module of claim 2, wherein the plurality of interconnects comprise a plurality of solder balls.

4. The multi-chip module of any preceding claim, wherein a first semiconductor package of the at least two semiconductor packages is laterally adjacent to a second semiconductor package of the at least two semiconductor packages such that the substrate of the first semiconductor package is substantially co-planar with the substrate of the second semiconductor package.

5. The multi-chip module of any preceding claim, wherein at least one of the at least two semiconductor packages comprises a plurality of dies.

6. The multi-chip module of any preceding claim, wherein at least one of the at least two semiconductor packages includes a shielding layer coupled to at least a respective first surface of the at least one of the at least two semiconductor packages.

7. The multi-chip module of any preceding claim, further comprising:
an interconnect that couples the at least two semiconductor packages, the interconnect being encapsulated by the second encapsulation material.

8. The multi-chip module of claim 7, wherein the interconnect comprises a bond wire.

9. A method, comprising:
positioning a first semiconductor package and a second semiconductor package such that the first semiconductor package is laterally adjacent to the second semiconductor package, each of the first semiconductor package and the second semiconductor package having a first surface and a second surface that is opposed to the first surface, each of the second surfaces having a plurality of interconnects; and
at least partially encapsulating the first semiconductor package and the second semiconductor package in an encapsulation material.

10. The method of claim 9, said positioning comprising:
applying an adhesive material layer to the first surface of the first semiconductor package and the first surface of the second semiconductor package.

11. The method of claim 9 or 10, said at least partially encapsulating comprising:
applying at least one film layer over the plurality of interconnects of the first semiconductor package and the second semiconductor package;
applying an encapsulation material between the at least one film layer and the second surfaces of the first and second semiconductor packages; and
removing the at least one film layer, the plurality of interconnects of the first semiconductor package and the second semiconductor package being at least partially exposed through the encapsulation material.

12. The method of any of claims 9 to 11, wherein the plurality of interconnects comprise a plurality of solder balls.

13. The method of any of claims 9 to 12, wherein at least one of the first semiconductor package or the second semiconductor package comprises a shielding layer that substantially encloses at least one integrated circuit die on the first surface of the at least one of the first semiconductor package or the second semiconductor package.

14. The method of any of claims 9 to 13, further comprising:
electrically and mechanically coupling the first semiconductor package and the second semiconductor package with an interconnect; and
said at least partially encapsulating comprising encapsulating the interconnect with the second encapsulation material.

15. A semiconductor package, comprising:
a substrate having a first surface and a second surface that is opposed to the first surface;
one or more first interconnects coupled to the first surface of the substrate;
one or more second interconnects coupled to the first surface of the substrate; and
an encapsulation material that fully encapsulates the one or more first interconnects and the first surface of the substrate, and partially encapsulates the one or more second interconnects such that the one or more second interconnects are partially exposed through the encapsulation material.
